Europäisches Patentamt

(19) European Patent Office  (11) Publication number: **0 072 471**

Office européen des brevets  **B1**

(12) **EUROPEAN PATENT SPECIFICATION**

(45) Date of publication of patent specification: **08.01.86**  (51) Int. Cl.⁴: **G 06 F 3/02, H 03 M 11/00**

(21) Application number: **82106855.8**

(22) Date of filing: **29.07.82**

(54) **Keyboard unit control system.**

(30) Priority: **13.08.81 JP 125909/81**

(43) Date of publication of application:
**23.02.83 Bulletin 83/08**

(45) Publication of the grant of the patent:
**08.01.86 Bulletin 86/02**

(84) Designated Contracting States:
**DE FR GB IT NL**

(56) References cited:
**DE-A-2 852 558**
**GB-A-2 037 046**
**GB-A-2 047 448**

**ELECTRONIC ENGINEERING, vol. 53, no. 654,**
**July 1981, pages 25-26, London (GB);**
**A.B.WILLINSON: "Utilising a calculator as a**
**microprocessor display/keyboard".**

**MICROPROCESSORS, vol. 2, no. 2, April 1978,**
**pages 67-70, London (GB); R.MUNT**
**:"Microprocessor keyboard encoding."**

(73) Proprietor: **Kabushiki Kaisha Toshiba**
**72, Horikawa-cho Saiwai-ku**
**Kawasaki-shi Kanagawa-ken 210 (JP)**

(72) Inventor: **Ishii, Takatoshi**
**3-23-6, Imai**
**Oome-shi Tokyo (JP)**
Inventor: **Touyama, Osamu**
**2016 Shinmachi**
**Oome-shi Tokyo (JP)**

(74) Representative: **Henkel, Feiler, Hänzel & Partner**
**Möhlstrasse 37**
**D-8000 München 80 (DE)**

## Description

The present invention relates to a keyboard unit control system which connects a keyboard unit to a central processing unit through a system bus comprising: latch means for latching scanning data supplied from said central processing unit, the scanning data including block selection data to select one of a plurality of scanning blocks, each comprised of scanning lines, and scanning line selection data to determine one of the scanning lines in the selected scanning block; and scan line selecting logic means, connected to said latch means and said keyboard unit, for selectively supplying the scanning data to said keyboard unit on the basis of the scanning data supplied from said latch means.

There are generally two scanning systems of the keyboard with a matrix: a software supervising/scanning system and a hardware scanning system. In the software supervising/scanning system, the amount of hardware required is relatively small. However, the scanning operation must be always supervised, resulting in a heavy load on the software. If parallel operations such as arithmetic operations are required, they may not be satisfactorily performed. Meanwhile, in the hardware scanning system, simple software can be used, but the system itself becomes large in size, resulting in high cost. Further, the software and hardware scanning systems described above are of a dynamic scanning type, so that noise may be generated. A radio wave shield must be arranged to shield noise, resulting in a higher cost. Further, if a number of keys are arranged in the keyboard unit, the mechanism becomes bulky and an LSI device suitable to control such a keyboard unit has not been developed.

This document "Micro-processors", Volume 2, No. 2, April, 1978, pages 67 to 70 discloses a keyboard encoder which connects a key matrix to a microprocessor through a bit data bus. During normal operation the microprocessor is executing a loop which tests each half of the matrix for any key-operated condition if no key is found a short delay is performed and the matrix retested; i.e., the keyboard encoder always scans each line of the key matrix to check whether or not any keys are depressed. Therefore, this known keyboard encoder performs dynamic scan.

Furthermore, the document DE—A—28 52 558 discloses a key scanning circuit which uses scanning line select signals performing first and second scanning procedures. The first procedure is static scanning (initiated by setting a flipflop) and recognizes whether any key is operated. The second procedure is line scanning and determines which key is operated. Block scanning and the use of a computer for this purpose are not disclosed.

Finally, the document GB—A—2037046 describes key input circuits in which a static scanning is performed such that scanning starts upon the depression of a key and stops when the key is released. When a key is depressed, a scan clock signal is supplied to a counter through an OR gate and a NAND gate. After receiving the scan clock signal, the counter outputs a signal to a flip-flop which then produces a signal which is supplied to key switches through a further OR gate to execute scanning. The key input circuits form a matrix which is subdivided in two groups. To the first matrix a switch group are directly supplied the key scan signals while the second matrix switch group are supplied the key scan signals through integration circuits.

It is an object of the present invention to eliminate the conventional drawbacks and to provide a keyboard unit control system wherein scanning matrix lines are grouped to increase the number of scanning lines with a small amount of hardware and wherein a heavy load on software is decreased by static scanning utilizing interrupt detection.

In order to achieve the above and other objects, there is provided according to the present invention a keyboard unit control system as defined above and which is characterized in that the keyboard unit is normally statically scanned by means of an interrupt detector performing an interrupt operation of said central processing unit if any key of the keyboard is operated, and that during said interrupt operation said central processing unit controls said latch means and said scan line selection logic means by first scanning in units or blocks and then scanning the scanning lines within the selected block containing the operated key.

In this keyboard unit control system, before any scanning is done, the central processing unit receives an interruption signal informing it that a key has been depressed, and the block scanning is done before the line scanning, thus reducing the scanning load.

According to the keyboard unit control system of the present invention, a small amount of hardware and a small number of bits provide a great number of scanning lines. Other effects are summarized below:

i) Since the block comprised of scanning lines is scanned, high speed scanning is performed;

ii) When no interrupt operation is performed, the load of the software becomes normally substantially zero (dynamic scanning is not performed); and

iii) Since static scanning is normally performed, little, if any noise is produced.

One way of carrying out the invention is described in detail below with reference to the drawings which illustrate only one specific embodiment, in which:

Fig. 1 is a block diagram of a keyboard unit control device according to one embodiment of the present invention;

Figs. 2A and 2B are views showing bit assignments of ports A and B of the device shown in Fig. 1;

Fig. 3 is a detailed block diagram of the periphery of a keyboard unit shown in Fig. 1;

Fig. 4 is a circuit diagram showing the internal arrangement of the scan line selecting logic shown in Figs. 1 and 3; and

Fig. 5 is a circuit diagram of a key input detector used in an interrupt detector shown in Fig. 3.

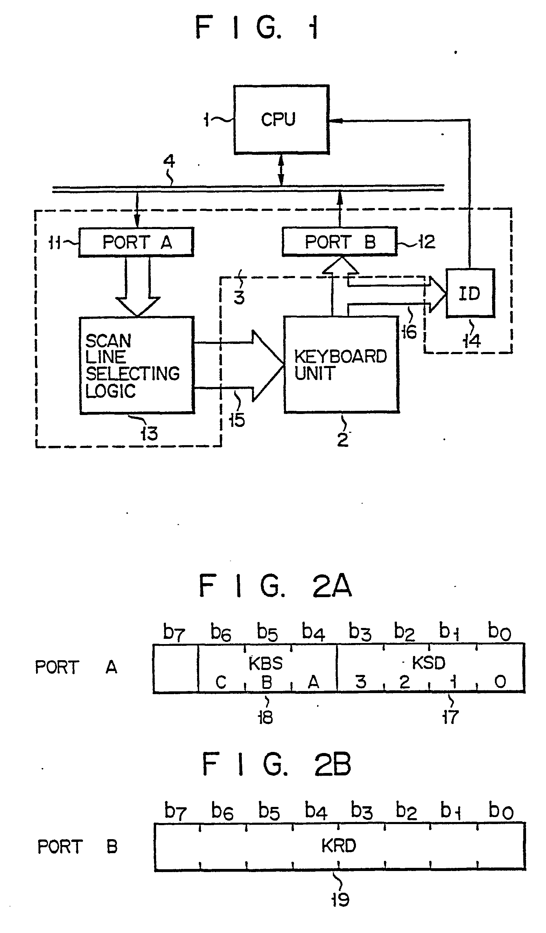

Fig. 1 is a block diagram of a keyboard unit control device according to one embodiment of the present invention. A central processing unit 1 (to be referred to as a CPU for brevity hereinafter) which comprises a microprocessor is connected to a scan line selecting logic 13 through a system bus 4 and a port A which is represented by reference numeral 11. The Z80A microprocessor (Zilog Corporation, U.S.A.) may be used as the CPU 1. The scan line selecting logic 13 is connected to a keyboard unit 2 through scanning lines 15. The scanning lines 15 consist of 12 scanning lines (4 lines × 3 blocks). The keyboard unit 2 is connected to an interrupt detector 14 through a return line 16 and to the CPU 1 through the system bus 4 and a port B which is represented by reference numeral 12. Interface module Z80APIO (Zilog Corporation, U.S.A.) is suitable for the ports A and B and the interrupt detector 14.

Figs. 2A and 2B show the respective bit assignments of the ports A and B shown in Fig. 1. Referring to Fig. 2A, a scanning data selection register 17 is assigned from the 0th bit (b0) to the 3rd bit (b3) of the port A, and a block selection register 18 is assigned from the 4th bit to the 6th bit thereof. Four of the scanning lines 15 are specified in the scanning data selection register 17, while 3 blocks are specified in the block selection register 18.

Referring to Fig. 2B, return data (KRD) indicating correspondence between keyboard scanning and depression of a key are stored from the 0th bit to the 7th bit of the port B. If the operator does not depress a key, each return data bit (0th bit to 7th bit) is all logic "1". However, when the operator presses a key corresponding to a scanning line, the corresponding return line is set to logic "0". Therefore, a bit corresponding to the return line is set to logic "0".

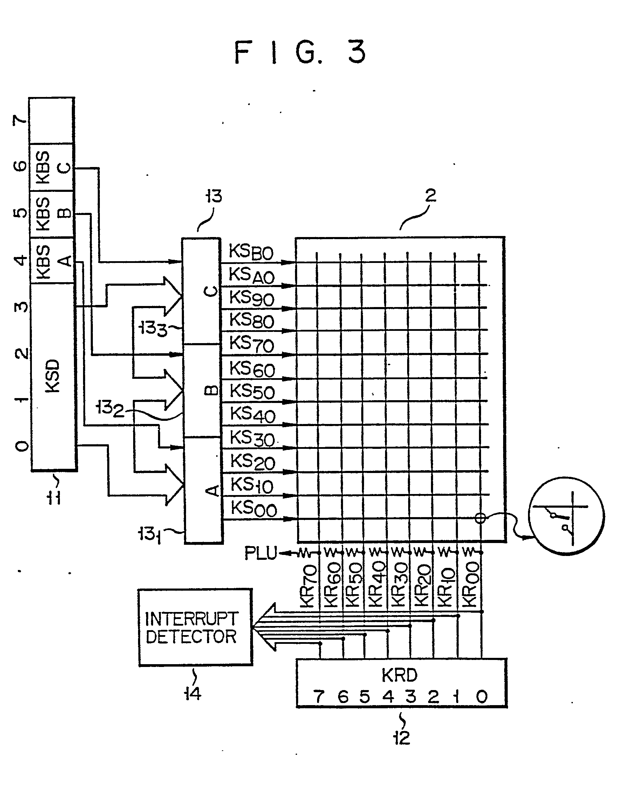

Fig. 3 is a detailed block diagram of the periphery of the keyboard unit. The same reference numerals used in Fig. 1 denote the same or similar parts, and a detailed description thereof will be omitted. Four-bit data from the scanning data selection register 17 and three-bit data from the block selection register 18 are stored in blocks A, B and C of the scan line selecting logic 13. These blocks A, B and C are respectively represented by reference numerals $13_1$, $13_2$ and $13_3$. The keyboard unit 2 is constituted by a diode matrix (12 rows × 8 columns). Therefore, scanning data KS00 through KSB0 which number 12 are supplied to the 12 rows of the keyboard unit 2, respectively. Meanwhile, return data KR00 through KR70, which number 8, are supplied from the 8 columns of the keyboard unit 2 to the port B and to the interrupt detector 14.

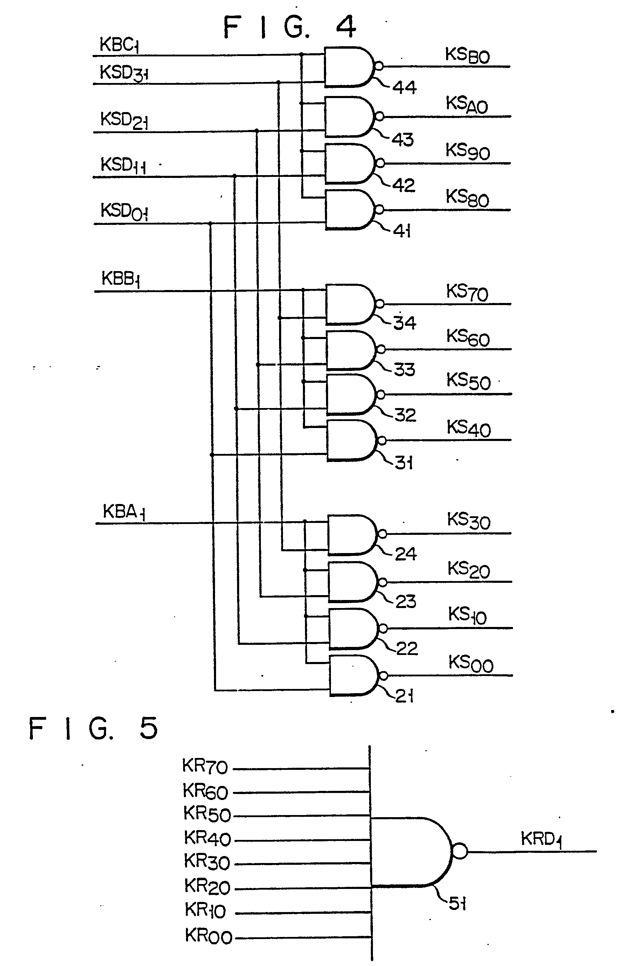

Fig. 4 is a circuit diagram of the scan line selecting logic 13 shown in Fig. 3. The blocks A, B and C each comprises 4 NAND gates. The 4th-bit data (KBA1) is commonly supplied from the block selection register 18 of the port A to one input terminal of each one of NAND gates 21, 22, 23 and 24 of the block A, while 0th-, 1st-, 2nd and 3rd-bit data (KSD01, KSD11, KSD21 and KSD31) are respectively supplied from the scanning data selection register 17 of the port A to the other input terminals thereof. The 5th-bit data (KBB1) is commonly supplied from the block selection register 18 of the port A to one input terminal of each one of NAND gates 31, 32, 33 and 34 of block B, while all the data (KSD01, KSD11, KSD21 and KSD31) are respectively supplied from the scanning data selection register 17 to the other input terminals of the NAND gates 31, 32, 33 and 34 thereof. Further, the 6th-bit data (KBC1) is commonly supplied from the block selection register 18 of the port A to one input terminal of each one of NAND gates 41, 42, 43 and 44 of the block C, while all the data (KSD01, KSD11, KSD21, KSD31) are respectively supplied from the scanning selection register 17 to the other input terminals of the NAND gates 41, 42, 43 and 44 thereof. Outputs from the NAND gates 21 to 24, 31 to 34 and 41 to 44 represent the scanning data KS00 and KSB0.

Fig. 5 is a detailed circuit diagram of a key input detector used in the interrupt detector 14. The return data KR00 to KR70 are supplied to a NAND gate 51. If any one of the input data is logic "0", the NAND gate 51 produces an interrupt request signal KRD1.

The mode of operation of the keyboard unit control device according to one embodiment of the present invention will be described in detail. The CPU 1 sets all data for scanning every line in the port A and waits for a key input interrupt. If the key input interrupt takes place, the CPU 1 can detect a depressed key in accordance with the following method, in which the CPU 1 determines a block to which the depressed key belongs and then detects the depressed key: First, all the bits of the PORT A 11 are set on. With this state, when any key is pressed, the signal corresponding to the key, i.e., the corresponding one of data KR00 to KR70 becomes low and the signal KRD1 shown in Fig. 5 becomes high. The signal corresponding to the data KRD1 is supplied to the CPU 1 as an interrupt signal. The interrupt signal informs the CPU 1 that some key has been pressed. To confirm which key is pressed, the CPU 1 scans the scanning line for every four lines to find out the block which has the pressed key. This scanning is performed as follows:

The KSD bits (bit 0 to bit 3) and any one of the KBS A bit (bit 4), KBS B bit (bit 5) and KBS C bit (bit 6) is set high and the first four scanning lines are scanned. If these lines include the line corresponding to the pressed key, one of the bits of the PORT B 12 is low. If no bits are low, then the operation with one of the remaining bits 4, 5, or 6 being set high is performed until it is found that the PORT B 12 has a low bit. In this manner, it is possible to determine the block to which the pressed key belongs. To find out which key in the block has actually been pressed, the KSD bits 0 to 3 are sequentially set high and the outputs of the PORT B 12 are checked.

Thus, according to this method, when all the data from the 4th bit through the 6th bit and 0th bit through the 3rd bit of the port A are logic "1", the data satisfy all the conditions of the NAND gates 21 to 24, 31 to 34 and 41 to 44 as shown in Fig. 4. Thus, scanning is performed. As a result, all the scanning lines are set to logic "0". In this condition, if the operator depresses any one of the keys, data is obtained on the corresponding return line which is then set to logic "0". The interrupt detector 14 interrupts the operation of the CPU 1 through a signal line at which data KRD1 appears. The CPU 1 thus determines which key is depressed in accordance with data in the port B.

If one of the data corresponding to the 4th through the 6th bits and all the data corresponding to the 0th through the 3rd bits of the port A are set to logic "1", the four NAND gates are rendered conductive corresponding to one of the 4th through 6th bits whose data is logic "1". Thus, four lines are simultaneously scanned.

## Claims

1. A keyboard unit control system which connects a keyboard unit (2) to a central processing unit (1) through a system bus (4), comprising:
latch means (11) for latching scanning data supplied from said central processing unit (1), the scanning data including block selection data to select one of a plurality of scanning blocks, each comprised of scanning lines, and scanning line selection data to determine one of the scanning lines in the selected scanning block; and
scan line selecting logic means (13), connected to said latch means (11) and said keyboard unit (2), for selectively supplying the scanning data to said keyboard unit (2) on the basis of the scanning data supplied from said latch means (11),
characterized in that the keyboard unit (2) is normally statically scanned by means of an interrupt detector (14) performing an interrupt operation of said central processing unit (1) if any key of the keyboard unit is operated, and that during said interrupt operation said central processing unit (1) controls said latch means (11) and said scan line selection logic means (13) by first scanning in units of blocks and then scanning the scanning lines within the selected block containing the operated key.

2. A system according to claim 1, characterized in that said interrupt detecting means (14) has gate means (51) for gating return data from said keyboard unit (2) to the processing unit (1).

3. A system according to claim 1, characterized in that said scan line selecting logic means (13) comprises a plurality of gate blocks (21 to 24, 31 to 34, 41 to 44) each of which has one input terminal receiving the block selection data and the other input terminal receiving the scanning line selection data.

## Patentansprüche

1. Tastaturüberwachungssystem zur Verbindung einer Tastatureinheit (oder Tastenfeldeinheit) (2) mit einer Zentraleinheit (1) über ein System-Bus (4), umfassend
eine Verriegelungseinrichtung (11) zum Verriegeln von durch die Zentraleinheit (1) gelieferten Abtastdaten, die Blockwähldaten zum Wählen eines blocks aus einer Anzahl von Abtastblöcken, jeweils bestehend aus Abtastzeilen, und Abtastzeilenwähldaten zur Bestimmung einer der Abtastzeilen im gewählten Abtastblock enthalten, und
eine mit der Verriegelungseinrichtung (11) und der Tastatureinheit (2) verbundene Abtastzeilenwähl-Logikeinrichtung (13) zur selektiven Lieferung der Abtastdaten zur Tastatureinheit (2) auf der Grundlage der von der Verriegelungseinrichtung (11) gelieferten Abtastdaten,
dadurch gekennzeichnet, daß die Tastatureinheit (2) normalerweise statisch durch einen Unterbrechungsdetektor (14) abtastbar ist, der eine Unterbrechungsoperation der Zentraleinheit (1) ausführt, wenn eine der Tasten der Tastatureinheit betätigt wird, und daß die Zentraleinheit (1) während der Unterbrechungsoperation die Verriegelungseinrichtung (11) und die Abtastzeilenwähl-Logikeinrichtung (13) zunächst durch Abtasten in Einheiten von Blöcken und dann durch Abtasten der Abtastzeilen im gewählten Block, der die betätigte Taste enthält, ansteuert.

2. System nach Anspruch 1, dadurch gekennzeichnet, daß die Unterbrechungsdetektoreinrichtung (14) eine Gattereinrichtung (51) zum Durchtasten von Rücklaufdaten von der Tastureinheit (2) zur Zentraleinheit (1) aufweist.

3. System nach Anspruch 1, dadurch gekennzeichnet, daß die Abtastzeilenwähl-Logikeinrichtung (13) mehrere Gatterblöcke (21—24, 31—34, 41—44) aufweist, die jeweils an einer Eingangsklemme die Blockwähldaten und an der anderen Eingangsklemme die Abtastzeilenwählten abnehmen.

## Revendications

1. Système de commande de clavier qui connecte un clavier (2) à une unité centrale de traitement (1) par l'intermédiaire d'un bus (4) du système, comprenant:
un moyen de verrouillage (11) servant à verrouiller des données de balayage délivrées par ladite unité centrale de traitement (1), les données de balayage comportant des données de sélection de bloc visant à sélectionner l'un parmi plusieurs blocs de balayage, chacun constitué de lignes de balayage, et des données de sélection de ligne de balayage visant à déterminer une parmi les lignes de balayage du bloc de balayage choisi; et
un moyen logique (13) de sélection de ligne de balayage, connecté audit moyen de verrouillage (11) et audit clavier (2), servant à sélectivement délivrer les données de balayage audit clavier (2) sur la base des données de balayage délivrées par ledit moyen de verrouillage (11),

caractérisé en ce que le clavier (2) est normalement balayé de manière statique par l'intermédiaire d'un détecteur d'interruption (14) effectuant une opération d'interruption de ladite unité de centrale de traitement (1) si l'une quelconque des touches du clavier est actionnée, et en ce que, pendant ladite opération d'interruption, ladite unité centrale de traitement (1) commande ledit moyen de verrouillage (11) et ledit moyen logique (13) de sélection de ligne de balayage en commençant par balayer en unités de blocs, puis en balayant les lignes de balayage à l'intérieur du bloc choisi contenant la touche actionnée.

2. Système selon la revendication 1, caractérisé en ce que ledit moyen de détection d'interruption (14) possède une porte (51) servant à laisser passer, sous conditions, des données de retour, allant dudit clavier (1) à l'unité de traitement (1).

3. Système selon la revendication 1, caractérisé en ce que ledit moyen logique (13) de sélection de ligne de balayage comprend plusieurs blocs de portes (21 à 24, 31 à 34, 41 à 44) qui reçoivent chacun, par une première borne d'entrée, les données de sélection de bloc et, par son autre borne d'entrée, les données de sélection de ligne de balayage.

# F I G. 1

# F I G. 2A

# F I G. 2B

# F I G. 3

FIG. 4

FIG. 5